# EUROPÄISCHE PATENTSCHRIFT

(11) **EP 2 271 947 B1**
(45) Veröffentlichungstag und Bekanntmachung des Hinweises auf die Patenterteilung: **06.02.2019**
(21) Anmeldenummer: 09741725.7
(22) Anmeldetag: 02.04.2009
(51) Int. Cl.: G01R 1/04

(54) **VORRICHTUNG ZUR KONTAKTIERUNG EINES T/R-MODULS MIT EINER TESTEINRICHTUNG**
APPARATUS FOR CONTACTING A T/R MODULE WITH A TEST DEVICE
DISPOSITIF POUR ÉTABLIR UN CONTACT ENTRE UN MODULE T/R ET UN SYSTÈME DE TEST

(30) Priorität: 09.05.2008 DE 102008023130
(43) Veröffentlichungstag der Anmeldung: 12.01.2011
(73) Patentinhaber: HENSOLDT Sensors GmbH, 82024 Taufkirchen (DE)
(72) Erfinder: SCHMEGNER, Karl-Ernst, 89278 Nersingen (DE); MÜLLER, Thomas, Johannes, 89155 Erbach (DE); HÖFER, Georg, 89173 Lonsee (DE)
(74) Vertreter: LifeTech IP Spies & Behrndt Patentanwälte PartG mbB
(86) Internationale Anmeldenummer: PCT/DE2009/000459
(87) Internationale Veröffentlichungsnummer: WO 2009/135452

(56) Entgegenhaltungen:
- EP-A- 0 388 485
- EP-A- 0 419 725
- US-A- 4 707 656
- US-A- 4 947 111
- US-A1- 2007 004 238

## Beschreibung

Die Erfindung betrifft eine Vorrichtung zur Kontaktierung eines T/R-Moduls mit einer Testeinrichtung. T/R-Modul steht dabei für Transmit/Receive-Modulen, wie sie insbesondere in aktiven Antennen im HF-Bereich zum Einsatz kommen.

Die Kontaktierung und damit die Charakterisierung von T/R-Modulen (Prüfling) kann nach dem Stand der Technik durch den Einbau in spezielle Messhalterungen erfolgen. In diesen wird die HF-Verbindung zur Tester-Umgebung durch koaxiale Stecker und zum Prüfling durch Adaptoren mit gebondeten Drähten und/oder Bändchen hergestellt. In ähnlicher Weise erfolgt die Versorgung mit DC und die Verbindung zu den Steuersignalen. Nach erfolgtem Test werden die gebondeten Verbindungen wieder entfernt. Auf den Anschlusspads der Prüflinge bleiben Reste der Verbindung und sichtbare Spuren zurück.

Dieses mechanisch aufwändige und zudem nicht spurenlose (bzw. rückstandsfreie) Kontaktieren von Prüflingen kann stattdessen mit Hilfe von Nadeladaptern für die niederfrequente Ansteuerung bzw. DC-Versorgung durchgeführt werden. Die hochfrequenten Signale werden hierfür mit speziellen koaxialen Prüfspitzen (HF-Probes) zugeführt. Dabei muss auch bei dieser Art der Kontaktierung beachtet werden, dass sowohl die Nadeln als auch die Prüfspitzen beim Kontaktieren auf den Anschlusspads Spuren (Kratzer) hinterlassen, die die weitere Verarbeitung der Module (Einbau in ein System per Bondverbindung) beeinträchtigen können. Zudem sind die Anschlusspads aus Platzgründen und aufgrund von HF-technischen Anforderungen sehr klein gehalten. Um für die Messung eine sichere Kontaktierung der Module zu gewährleisten, müssen deshalb sowohl der Prüfling als auch die Prüfspitzen unabhängig voneinander unter Zuhilfenahme eines Mikroskops manuell optisch zueinander ausgerichtet werden. Nur aufgrund dieser recht aufwändigen Vorgehensweise wird sichergestellt, dass die individuellen mechanischen Toleranzen der Prüflinge sich nicht störend auf die elektrischen Eigenschaften der Module auswirken. Ferner ist anzumerken, dass sich die Qualität der Kontaktierung direkt auf die Güte der Messergebnisse auswirkt und qualitativ hochwertige Kontaktierungen nur von erfahrenem Bedienpersonal erreicht werden.

Bei dieser Art der Kontaktierung müssen die einzelnen Prüfspitzen individuell ausgerichtet werden, typischerweise unter Anwendung optischer Methoden unter einem Mikroskop, was sehr zeitaufwändig ist. Darüber hinaus ist die Güte der Kontaktierung stark abhängig von den Fähigkeiten des Bedienpersonals.

In der DE 41 07 248 A1 ist eine Messanordnung für eine planare Schaltung beschrieben, bei der mittels einer Schiebeeinrichtung, die mehrere schiefe Ebenen umfasst, die planare Schaltung gegen die Kontaktelemente einer Kontaktiereinheit bewegt wird. Weiterer Stand der Technik findet sich in den Dokumenten EP0419725 und EP0388485.

Aufgabe der vorliegenden Erfindung ist es deshalb, eine Vorrichtung zur Kontaktierung von T/R-Modulen zu schaffen, mit der die Nachteile der vorstehend geschilderten Kontaktiermethoden überwunden werden, insbesondere sollte eine leicht zu handhabende, gut reproduzierbare Kontaktierung hoher Güte geschaffen werden. Diese Aufgabe wird mit der Vorrichtung gemäß Patentanspruch 1 gelöst. Vorteilhafte Ausführungen sind Gegenstand von Unteransprüchen.

Gemäß der Erfindung wird die optische Ausrichtung des Prüflings durch eine mechanische Führung einer Kontaktiereinheit ersetzt, welche nach Erreichen einer definierten Endposition das zu prüfende T/R-Modul kontaktiert. Die mechanische Führung wird mittels einer Schiebeeinrichtung realisiert, die mehrere schiefe Ebenen umfasst, wobei mit den schiefen Ebenen eine Schiebebewegung der Schiebeeinrichtung in eine zur Schieberichtung senkrechte Bewegung der Kontaktiereinheit auf das T/R-Modul zu gewandelt wird. Mittels Passstiften erfolgt die Ausrichtung des zu prüfenden T/R-Moduls. Ein an der Kontaktiereinheit angeordnetes Leitungssubstrat stellt die Verbindung zu den Anschlusstoren der Testeinrichtung her. Es ist als Triplate-Leitung ausgebildet. Die Kontaktiereinheit weist Kontaktelemente (z.B. Federkontaktstifte) auf und verbindet damit das Leitungssubstrat mit den entsprechenden Kontaktpads des T/R-Moduls.

Zur Erreichung einer sicheren und zuverlässigen Verbindung zu den T/R-Modulen entfällt bei der erfindungsgemäßen Art der Kontaktierung das individuelle Ausrichten der Prüfspitzen zum Prüfling. Das hierzu erforderliche Betrachten durch ein Mikroskop entfällt ebenfalls.

Alle erforderlichen Kontakte, d.h. neben den hochfrequenten Signalen auch die niederfrequenten Signale oder DC-Signale, können in einem Arbeitsgang sicher und gleichzeitig geschlossen werden.

Mit der erfindungsgemäßen Vorrichtung ist die Güte der Kontaktierung weitestgehend unabhängig von den Fähigkeiten des Bedienpersonals. Es wird somit sichergestellt, dass die Eigenschaften der Prüflinge unverfälscht wiedergegeben werden.

Ein weiterer Vorteil ist ferner, dass die Verbindungselemente (z.B. Federkontaktstifte) selbst nach mehrmaligem Kontaktieren desselben Prüflings weder Rückstände noch sichtbare Spuren auf den Kontaktierflächen des Moduls hinterlassen. Auch können die Federkontaktstifte einer hohen Anzahl von Kontaktierzyklen ausgesetzt werden, bevor irgendwelche Verschleißerscheinungen an den Kontakten feststellbar sind.

Ein weiterer Vorteil ist die sehr einfach durchzuführende Kalibrierung des Messplatzes, bei der dasselbe Kontaktierprinzip angewandt werden kann. Die hierfür angefertigten Kalibrierelemente besitzen denselben Aufbau wie das Leitungssubstrat und weisen unterschiedlich lange Triplate-Leitungen, die auf einem Metallträger montiert sind, auf. Der Metallträger besitzt eine an den Prüfling angenäherte Außenkontur mit der gleichen Geometrie der Anschlüsse wie der Prüfling. Die Kalibrierelemente sind deshalb genauso einfach in die Testhalterung einzulegen und zu kontaktieren wie die T/R-Module. Hierfür ist kein zusätzlicher Aufwand zum Einstellen und Ausrichten erforderlich. Selbst die Reihenfolge des Einlegens kann vom Steuerprogramm dem Bediener vorgegeben werden.

Die erfindungsgemäße Art der Kontaktierung ist problemlos anwendbar bei einer automatischen Bestückung und somit auch bei einem automatischen Testen von größeren Stückzahlen im Rahmen einer Serienfertigung von T/R-Modulen.

Die Erfindung wird anhand von Ausführungsbeispielen unter Bezugnahme auf Figuren näher erläutert. Es zeigen:
- Fig. 1: eine erfindungsgemäße Vorrichtung zur Kontaktierung mit mechanischer Führung in 3D-Darstellung (ohne T/R-Modul);
- Fig. 2: eine erfindungsgemäße Vorrichtung zur Kontaktierung mit mechanischer Führung in 3D-Darstellung (mit eingelegtem T/R-Modul);
- Fig. 3: die Schiebeeinrichtung der erfindungsgemäßen Vorrichtung in 3D-Darstellung;
- Fig. 4: eine erfindungsgemäße Vorrichtung mit kontaktiertem T/R-Modul in Querschnittsdarstellung (Detail);
- Fig. 5: ein Leitungssubstrat in Querschnittsdarstellung;
- Fig. 6: den Anschluss eines Koaxialsteckers am Ende des Leitungssubstrats;
- Fig. 7: ein Leitungssubstrat in Draufsicht;
- Fig. 8: Kontaktierelemente am Übergang vom T/R-Modul zur Kontaktiereinheit;
- Fig. 9: Kontaktierelemente am Übergang von der Kontaktiereinheit zum Leitungssubstrat.

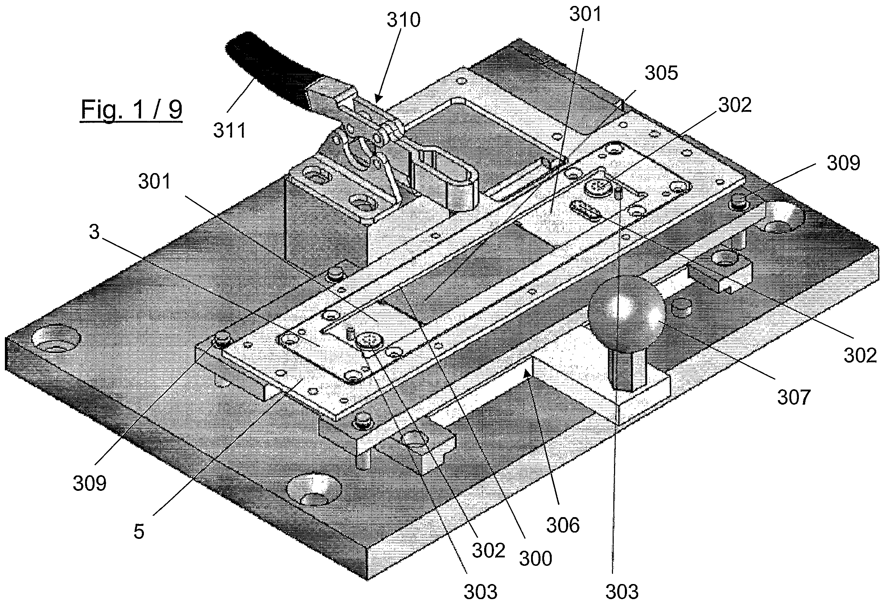

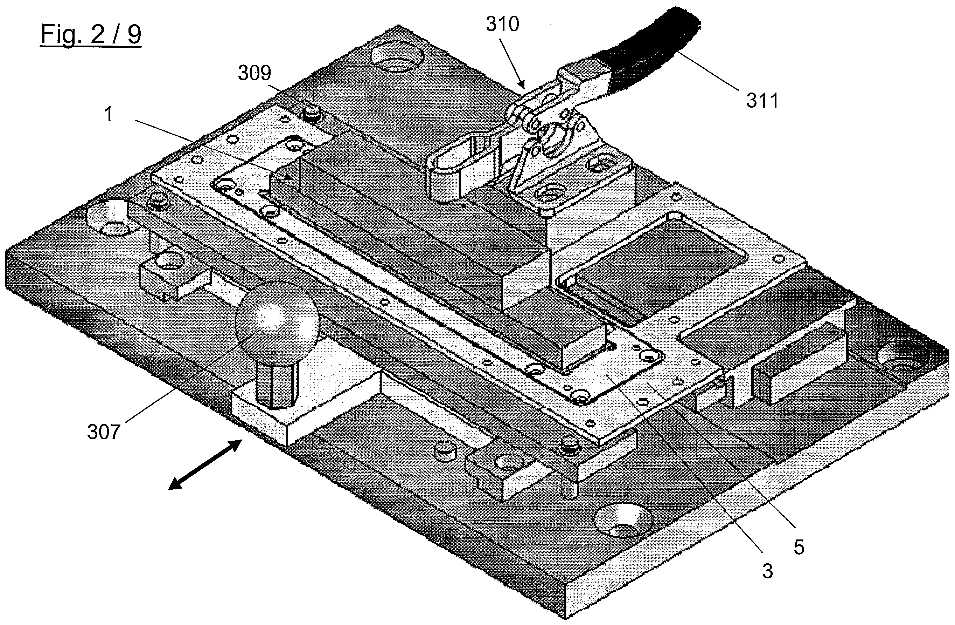

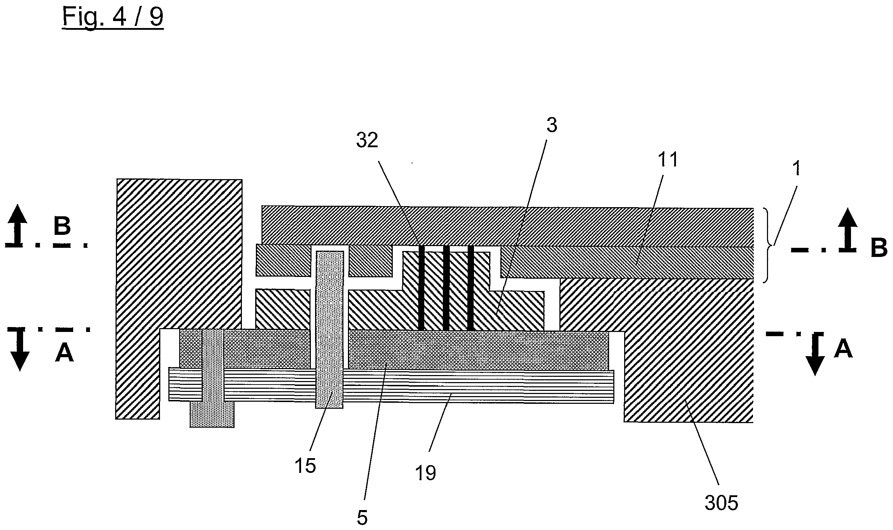

Fig. 1 zeigt eine erfindungsgemäße Vorrichtung zur Kontaktierung in 3D-Darstellung und zwar in einem Zustand, bevor ein zu vermessendes T/R-Modul 1 (Fig. 2) eingelegt worden ist. Sie umfasst eine Kontaktiereinheit 3, die auf einem Leitungssubstrat 5 angeordnet ist. Leitungssubstrat 5 und Kontaktiereinheit 3 sind elektrisch über mehrere Kontakte miteinander verbunden, was weiter unten noch im Detail ausgeführt werden wird. Die Kontaktiereinheit weist Kontaktelemente, hier Federkontaktstifte 32 (Fig. 4) für die Kontaktierung des T/R-Moduls auf.

Die Kontaktiereinheit 3 weist eine zentrale wannenförmige Vertiefung 300 auf, in der das zu vermessende T/R-Modul eingelegt werden kann. Der Boden 301 dieser wannenförmigen Vertiefung 300 weist, wie man aus der Fig. 1 erkennt, mehrere erhabene Anschlussbereiche 302 für den elektrischen Kontakt mit dem T/R-Modul auf. Aus dem Boden 301 der wannenförmigen Vertiefung 300 ragt links und rechts jeweils ein Passstift 303 heraus. Diese dienen zur eindeutigen Ausrichtung und Zentrierung des einzulegenden T/R-Moduls bezogen auf die Kontakte der Kontaktiereinheit 3. Die wannenförmige Vertiefung 300 der Kontaktiereinheit 3 hat keinen durchgehenden Boden, sondern weist eine zentrale rechteckige Durchbrechung auf, durch welche die Abschlussplatte einer Temperiereinheit 305 ragt, mit der das T/R-Modul im Wärmekontakt steht, sobald es in die Vorrichtung eingelegt worden ist. Die Temperiereinheit 305 sorgt für eine konstante Temperatur der Prüfumgebung.

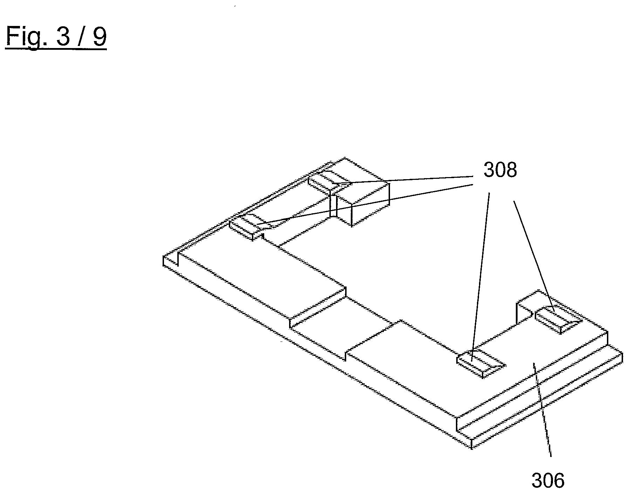

Das Niveau der Temperiereinheit 305 liegt im gezeigten Zustand der Vorrichtung etwas höher als der Boden 301 der wannenförmigen Vertiefung 300 der Kontaktiereinheit 3. Wenn nun ein T/R-Modul eingelegt wird, liegt es auf der Temperiereinheit 305 auf, hat aber zunächst noch keinen Kontakt zu der Kontaktiereinheit 3. Ein solcher Kontakt wird erst hergestellt, in dem eine Schiebeeinrichtung 306 an ihrem Schiebehebel 307 in Richtung auf die Kontaktiereinheit 3 geschoben wird. Die Schiebeeinrichtung 306, die in Fig. 3 im Detail (ohne Schiebehebel) dargestellt ist, weist vier schiefe Ebenen 308 auf, mit der die horizontale Schiebebewegung in eine vertikale lineare Bewegung der Kontaktiereinheit 3 mit daran angeordnetem Leitungssubstrat 5 umgesetzt wird. Vier Zylinderstifte 309, die über Buchsen geführt sind, garantieren die Linearbewegung der Kontaktiereinheit 3 ohne Verkippen. Der Boden des T/R-Moduls kann als mechanischer Anschlag für die Aufwärtsbewegung der Kontaktiereinheit 3 und dem damit verbundenen Leitungssubstrat 5 dienen. Es ist aber auch ein Anschlag unabhängig vom T/R-Modul möglich, z.B. an der Seite der Temperiervorrichtung (siehe z.B. Fig. 4). Beim Anschlag der Kontaktiereinheit oder des Leitungssubstrats werden die Federkontaktstifte der Kontaktiereinheit gleichzeitig mit den komplementären Kontaktelementen (hier: Kontaktflächen) des T/R-Moduls kontaktiert. Alle erforderlichen Kontakte können somit in einem Arbeitsgang sicher und gleichzeitig geschlossen werden.

Die Passstifte 15 sind auf einer Trägerplatte an der Unterseite des Leitungssubstrats verankert (siehe Fig. 4) und somit zusammen mit diesem beweglich. Die Länge der Passstifte 303 wird so gewählt, dass sie auch in abgesenkter Position der Kontaktiereinheit 3 über das Niveau der Temperiereinheit 305 hinausragen.

Der Hebel 311 ist Teil einer Fixiereinrichtung 310, mit der das T/R-Modul nach dem Einlegen mechanisch fixiert werden kann, in dem es von oben gegen die Temperiereinrichtung 305 gepresst wird.

Fig. 2 zeigt dieselbe Vorrichtung, nachdem das T/R-Modul 1 eingelegt ist. Bedienung und Funktionsweise der erfindungsgemäßen Vorrichtung ist wie folgt:
- das T/R-Modul 1 wird auf die Oberfläche der Temperiereinheit 305 (Fig. 1) gelegt;
- während des Einlegens wird das T/R-Modul 1 an den Passstiften 303 ausgerichtet;
- von oben wird die Fixiereinheit 310 auf das T/R-Modul 1 abgesenkt, diese drückt auf den geschlossenen Deckel des T/R-Moduls 1;
- durch horizontale Verschiebung am Schiebehebel 307 wird die Kontaktiereinheit 3 mit daran angeordnetem Leitungssubstrat 5 von unten an den Boden des T/R-Moduls 1 gedrückt und die Kontakte werden gleichzeitig geschlossen.

Nach der Messung wird zuerst die bauliche Einheit aus Kontaktiereinheit 3 und Leitungssubstrat 5 abgesenkt, in dem der Hebel 307 zurückgezogen wird. Dadurch werden die Kontakte wieder geöffnet. Nach dem Entriegeln der Fixiervorrichtung 310 am Hebel 311 kann das T/R-Modul entnommen werden. Dieser Ablauf gilt auch bei der Kalibrierung, bei der Kalibrier-Standards vermessen werden.

Mit der erfindungsgemäßen Vorrichtung können nicht nur verschlossene Module gemessen, sondern auch noch offene Module einem Vortest unterzogen werden. Zur Sicherstellung einer elektrisch wirksamen Abdeckung der offenen Module kann der lose aufliegende Deckel des Moduls mit der Fixiervorrichtung von oben auf den Rahmen des Moduls gepresst werden.

Die Fig. 4 zeigt einen senkrechten Schnitt durch eine Ausführung der erfindungsgemäßen Vorrichtung mit bereits kontaktiertem T/R-Modul 1 (gezeichnet ist nur die eine Hälfte der Vorrichtung, so dass sich die zentrale Temperiervorrichtung 305 nunmehr am rechten Rand in Fig. 4 befindet). Die Fig. ist stark schematisch und gibt nicht sämtliche Details der Fig. 1,2 und 5 wieder. Oben befindet sich das zu prüfende T/R-Modul 1 mit seiner Grundplatte 11 auf der Temperiereinheit 305 auf. Die vertikal bewegliche Baueinheit umfasst die Kontaktiereinheit 3 mit darin integrierten Kontaktstiften 32, das Leitungssubstrat 5 sowie eine Trägerplatte 19. Auf der Trägerplatte sind die Passstifte 15 verankert. Das Leitungssubstrat 5 schlägt an einen Anschlag an der Temperiervorrichtung 305 an. In dieser Position wird durch die Kontaktstifte 32 die Verbindung zwischen T/R-Modul 1 und Leitungssubstrat 5 hergestellt. Die Kontaktstifte 32 sind vorteilhaft so ausgebildet, dass sie federnd auf die Anschlussflächen des T/R-Moduls 1 drücken.

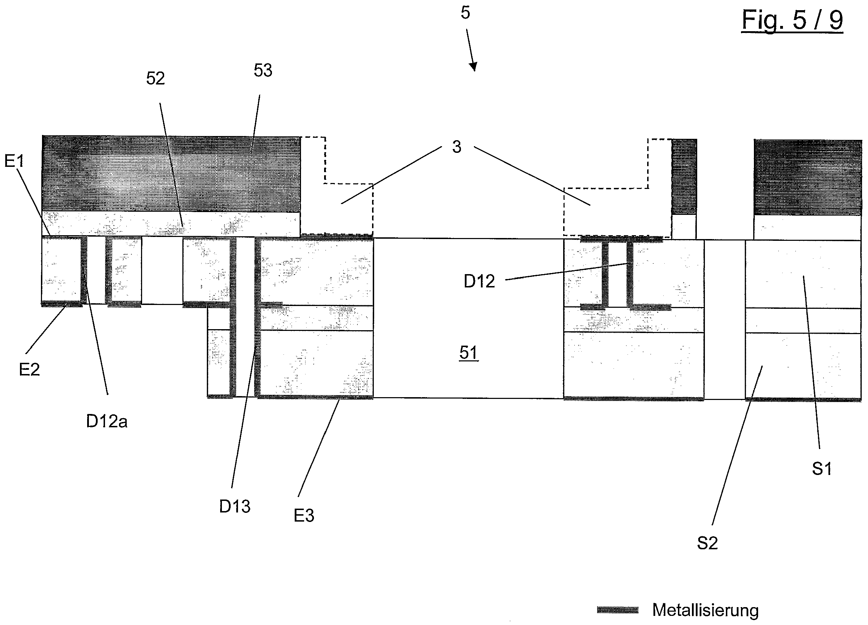

Fig. 5 zeigt das Leitungssubstrat 5 in Querschnittsdarstellung. Es ist als geschirmte Triplate-Leitung ausgebildet. Diese umfasst - durch zwei Substrate S1, S2 getrennt - drei parallele Metallisierungsebenen E1,E2,E3, wobei die mittlere Metallisierungsebene den streifenförmigen Innenleiter der Triplate-Leitung enthält. Zur Schirmung und Unterdrückung von höheren Moden oder unerwünschten Feldern können zusätzliche Maßnahmen vorgesehen werden, die weiter unten erläutert werden. Die Triplate-Leitung wird dadurch zu einer geschirmten Triplate-Leitung.

Da das Leitungssubstrat 5 die Form eines rechteckigen Rahmens aufweist, umschließt er einen offenen inneren Bereich 51 (dies kann z.B. durch Ausfräsen eines geschlossenen Substrats erreicht werden). Das Leitungssubstrat 5 ist mittels einer Klebeschicht 52 auf eine Trägerplatte 53 aus Metall, z.B. Aluminium, aufgeklebt. Die Lage des ebenfalls rahmenförmigen Kontaktierelements 3 ist durch gestrichelte Linien angedeutet. Daran schließt sich das zu prüfende T/R-Modul an (nicht eingezeichnet).

Innerhalb des Leitungssubstrats 5 befinden sich metallisierte Durchkontaktierungen D12, D12a, D13 sowohl von der oberen, modulseitigen E1 zur modulfernen E3 Metallisierungsebene wie auch von der oberen, modulseitigen E1 zur mittleren E2 Metallisierungsebene. Diese dienen entweder zur Leitung des HF-Signals oder zur Unterdrückung jedweder Art von Überkopplungen durch höhere Moden.
Ebenfalls in der Fig. 5 enthaltene Bohrungen ohne Metallisierung dienen zur mechanischen Befestigung der Teile untereinander.

Das Leitungssubstrat 5 weist an einem Ende einen Übergang von der geschirmten Triplate-Leitung zu einer geschirmten Koplanarleitung auf. Dazu wurde die untere, modulferne Metallisierungsebene E3 sowie das untere Substrat S2 bis zur mittleren Metallisierungsebene E2 entfernt. In diesem Bereich kann der Stecker zum Anschluss einer Koaxialleitung der Testeinrichtung angebracht werden.

Um im Übergangsbereich die Anregung von höheren Moden, welche sich entlang des Steckerflansches und dann weiter zwischen Leitungssubstrat 5 und metallischer Trägerplatte 53 ausbreiten können, zu unterdrücken, wird als Klebeschicht 52 vorteilhaft eine elektrisch leitfähige Klebefolie verwendet.

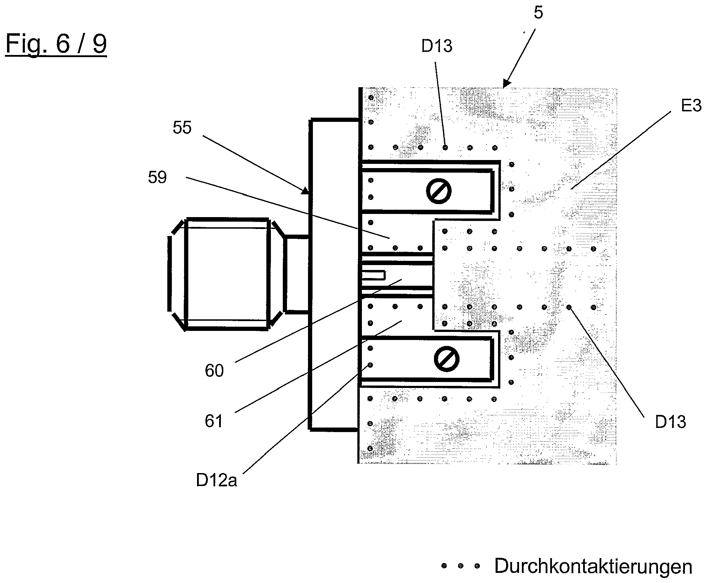

Fig. 6 zeigt diesen Übergangsbereich des Leitungssubstrats 5 in Untersicht, wobei der koaxiale Stecker 55 bereits angeschlossen ist. Die untere, modulferne Metallisierungsebene E3 sowie das darüberliegende Substrat S2 wurden entfernt, soweit es zur Montage des Steckers 55 notwendig ist. Dadurch ist der Innenleiter 60 der Triplate-Leitung auf der mittleren Metallisierungsebene E2 in diesem Bereich freigelegt. Der Innenleiter 60 wird mit dem Innenleiter des Koaxialsteckers 55 verbunden.

Zur Unterdrückung höherer Moden sind entlang der Außenkontur des koaxialen Steckers Durchkontaktierungen D13 zwischen den beiden äußeren Metallisierungsebenen E1,E3 der Triplate-Leitung vorgesehen. Für denselben Zweck sind entlang des Steckerflansches weitere Durchkontaktierungen D12a zwischen der unteren, modulnahen Metallisierungsebene E1 und der mittleren Metallisierungsebene E2 vorhanden.

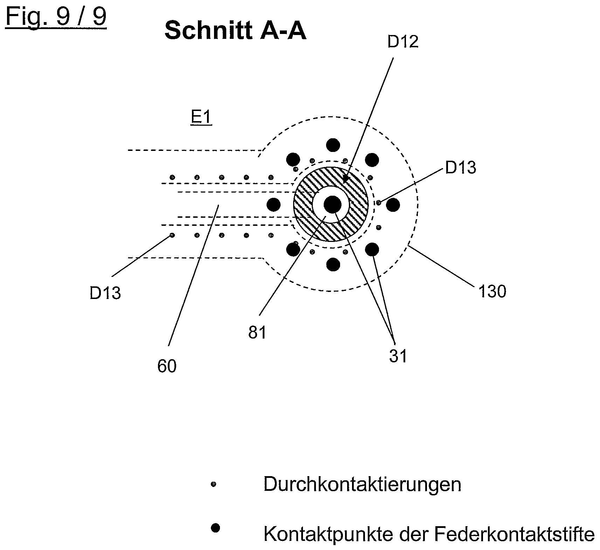

Zur Abschirmung des HF-Signals sind weitere Durchkontaktierungen D13 zwischen modulseitiger E1 und modulferner E3 Metallisierungsebene beidseitig entlang des Innenleiters 60 der mittleren Metallisierungsebene E2 vorhanden. Im Übergangsbereich, in dem die obere Metallisierungsebene E3 nicht vorhanden ist, verbinden diese Innenleiter-parallelen Durchkontaktierungen untere, modulnahe E1 und mittlere E2 Metallisierungsebene. Die Durchkontaktierungen D13 beiderseits des Innenleiters sind durch eine Metallisierungsfläche 130 (siehe Fig. 9), die auf beiden Seiten des Innenleiters 60 und parallel zu diesem verläuft, miteinander verbunden.

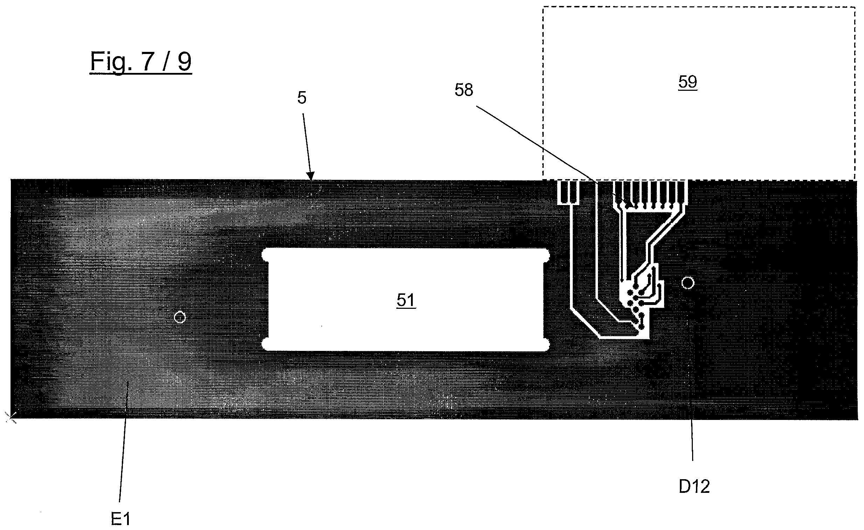

Fig. 7 zeigt das Leitungssubstrat 5 in Draufsicht, d.h. gesehen aus Richtung des T/R-Moduls. Man erkennt die modulseitige Metallisierungsebene E1 in ihrer rechtwinkligen, rahmenförmigen Ausbildung mit innerer Öffnung 51 für die Temperiereinheit.

Die Durchkontaktierung D12 dient zur Führung des HF-Signals vom T/R-Modul auf die mittlere Metallisierungsebene E2 der Triplate-Leitung. Sie wird weiter unten im Zusammenhang mit Fig. 9 noch näher erläutert werden.

Die in der Metallisierungsebene E1 eingearbeiteten Leitungsstrukturen 58 für die DC (Stromversorgung) und Steuersignale sind ebenfalls zu erkennen. Diese Leitungsstrukturen umfassen Kontaktflächen zur Kontaktierung mit den verwendeten Federkontaktstiften der Kontaktiereinheit. Die DC- und die Steuersignale können auf dieser Ebene direkt zu einer an dem Leitungssubstrat 5 angeordneten Leiterkarte 59 (deren Umriss ist in Fig. 7 gestrichelt eingezeichnet) geführt und von dort per mehrpoligem Stecker zu den Messgeräten der Testeinrichtung weitergeleitet werden.

Die Integration der auf der separaten Leiterkarte 59 angebrachten Stromversorgung in das Leitungssubstrat bieten einige Vorteile. So können kurze Leitungsverbindungen realisiert werden, die für einen störungsfreien Betrieb der T/R-Module erforderlich sind. Gleiches gilt für die HF-Verbindungen. Zur Unterdrückung bzw. Vermeidung von Verkopplungen und/oder Resonanzeffekten werden im Aufbau des Leitungssubstrats und auch in den weiteren Verbindungsstrukturen vorteilhaft kurze Verbindungswege realisiert.

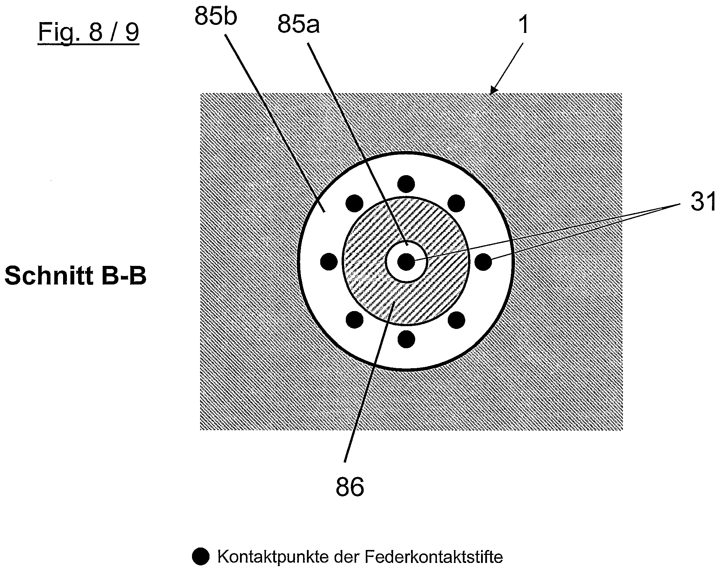

Fig. 8 zeigt eine Ansicht entlang der Linie B-B in Fig. 4. Man erkennt die metallischen Kontaktflächen 85a, 85b des HF-Signalausgangs des T/R-Moduls 1 (der Anschluss für das Eingangssignal ist identisch aufgebaut). Der Anschluss umfasst eine zentrale Kontaktfläche 85a, die von einer ringförmigen Kontaktfläche 85b umgeben ist. Dazwischen befindet sich ein Bereich 86 mit nicht metallisiertem Dielektrikum.

Diese Geometrie wird in die Gestaltung der Kontaktiereinheit übernommen. Die Kontaktpunkte 31 der Federkontaktstifte 32 (Fig. 4) innerhalb der Kontaktiereinheit sind ebenfalls markiert. Der Ground/Signal/Ground-Übergang wird mit dem zentralen Federkontaktstift auf der Kontaktfläche 85a hergestellt. Zur Unterdrückung von Wellen, die sich in der Kontaktiereinheit (diese wirkt als dielektrischer Wellenleiter) ausbreiten, werden innerhalb der Kontaktiereinheit zusätzliche Federkontaktstifte zur Schirmung des HF-Signals eingebracht, deren Kontaktpunkte 31 auf der ringförmigen Kontaktfläche 85b liegen. Der Abstand dieser äußeren Kontaktstifte wird so gewählt, dass die Schirmwirkung erreicht werden kann. Die Stifte bewirken in der Kontaktiereinheit 3 eine an eine Koaxialleitung angelehnte Führung des HF-Signals. Die Struktur einer an eine Koaxialleitung angenäherte Führung des HF-Signals setzt sich innerhalb des Leitungssubstrats fort, wie man Fig. 9 sowie der untenstehenden Beschreibung hierzu entnehmen kann.

Fig. 9 zeigt die Anschlussgeometrie für das HF-Signal an der Oberseite des Leitungssubstrats, also an der modulseitigen Metallisierungsebene E1 der Triplate-Leitung (Ansicht entlang der Linie A-A in Fig. 4). Ebenfalls eingezeichnet sind die Kontaktpunkte 31 der Federkontaktstifte 32 der Kontaktiereinheit 3.

Das HF-Signal wird mittels der Durchkontaktierung D12 (siehe Fig. 5) auf die mittlere Metallisierungsebene E2 der geschirmten Triplate-Leitung gebracht und dort über den Innenleiter der Triplate-Leitung weitergeführt. Die Durchkontaktierung D12 befindet sich in der Ansicht der Fig. 9 hinter der leitfähigen Kontaktfläche 81, auf der sich der Kontaktpunkt 31 eines Federkontaktstiftes 32 befindet. Der diese Kontaktfläche umgebende ringförmige nichtmetallisierte Bereich der Metallisierungsebene E1 ist schraffiert dargestellt.

Die Durchkontaktierung D12 für die Führung des HF-Signals ist innerhalb des Leitungssubstrats 5 vorteilhaft von weiteren Durchkontaktierungen D13 zur elektrischen Verbindung von modulseitiger und modulferner Metallisierungsebene umgeben. Derartige Durchkontaktierungen D13 sind auch beidseitig entlang des Innenleiters 60 (in der Fig. 9 gestrichelt dargestellt) der mittleren Metallisierungsebene E2 vorhanden. In der mittleren Metallisierungsebene sind die Durchkontaktierungen D13 über die Metallisierungsfläche 130 (gestrichelt eingezeichnet) miteinander verbunden. Entsprechend der Lage der Durchkontaktierungen D13 umgibt die Metallisierungsfläche 130 die Durchkontaktierung in einem kreisförmigen Abschnitt, der sich in zwei geradlinigen Abschnitten beidseitig und parallel zum Innenleiter 60 fortsetzt.

Diese zusätzlichen Maßnahmen sind zur Schirmung und zur Unterdrückung von höheren Moden und unerwünschten Ausbreitung von Feldern vorgesehen. In der mittleren Ebene E2 verläuft die Verbindungsleitung von der Durchkontaktierung D12 zum koaxialen Stecker 55 (Fig. 6) somit als geschirmte Triplate-Leitung.

## Patentansprüche

1. Vorrichtung zur Kontaktierung eines T/R-Moduls (1) mit einer Testeinrichtung zur Übertragung von HF-Signalen, mit folgenden Elementen:
- eine mechanisch geführte, rahmenförmige Kontaktiereinheit (3), welche eine Mehrzahl von Kontaktelementen (32) zur Kontaktierung des T/R-Moduls (1) umfasst,
- ein an der modulabgewandten Seite der Kontaktiereinheit (3) starr angeordnetes und mit ihr elektrisch verbundenes Leitungssubstrat (5), welches als Triplate-Leitung ausgebildet ist, über welches die HF-Signale zur Testeinrichtung weitergeführt werden können,
- einen oder mehrere Passstifte (15) zur definierten Ausrichtung des T/R-Moduls (1) gegenüber der Kontaktiereinheit (3),
- einer Fixiereinheit zur mechanischen Fixierung des T/R-Moduls (1),
- eine Schiebeeinrichtung (306), die mehrere schiefe Ebenen (308) umfasst, mit denen eine Schiebebewegung der Schiebeeinrichtung (306) in eine zur Schieberichtung senkrechte Bewegung der Kontaktiereinheit (3) auf das T/R-Modul (1) zu gewandelt wird, wobei beim Erreichen einer definierten Endposition der Kontaktiereinheit (3) der Kontakt zum T/R-Modul (1) über die Kontaktelemente (31) in einem Arbeitsgang hergestellt wird.

2. Vorrichtung nach Anspruch 1, **dadurch gekennzeichnet, dass** die Endposition der Kontaktiereinheit (3) durch Anschlag festgelegt ist.

3. Vorrichtung nach Anspruch 1 oder 2, **dadurch gekennzeichnet, dass** die Kontaktelemente (32) der Kontaktiereinheit (3) als Federkontaktstifte ausgebildet sind, die bei Erreichung der Endposition der Kontaktiereinheit metallische Kontaktflächen (81,85a,85b) an Leitungssubstrat (5) und T/R-Modul (1) berühren.

4. Vorrichtung nach Anspruch 3, **dadurch gekennzeichnet, dass** die Kontaktflächen (81,85a,85b) an Leitungssubstrat (5) und/oder T/R-Modul (1) einen zentralen Bereich (81,85a) und einen diesen umgebenden äußeren Bereich (85b) umfassen, wobei zentraler Bereich (81,85a) und äußerer Bereich (85b) von einem Bereich mit nicht metallisiertem Dielektrikum getrennt sind.

5. Vorrichtung nach Anspruch 3 oder 4, **dadurch gekennzeichnet, dass** zur Schirmung des HF-Signals das den zentralen Bereich (81,85a) der Kontaktflächen verbindende Kontaktelement (31) von weiteren Kontaktelementen (31), die den äußeren Bereich (85b) der Kontaktflächen verbinden, umgeben ist.

6. Vorrichtung nach einem der vorangehenden Ansprüche, **dadurch gekennzeichnet, dass** das HF-Signal über eine Durchkontaktierung (D12) von der modulseitigen (E1) zur mittleren (E2) Metallisierungsebene der Triplate-Leitung geführt wird.

7. Vorrichtung nach Anspruch 6, **dadurch gekennzeichnet, dass** die Durchkontaktierung für das HF-Signal (D12) von Durchkontaktierungen (D13) zwischen der modulseitigen (E1) und der modulfernen (E3) Metallisierungsebene der Triplate-Leitung umgeben ist.

8. Vorrichtung nach einem der vorangehenden Ansprüche, **dadurch gekennzeichnet, dass** beidseitig entlang des Innenleiters (60) der mittleren Metallisierungsebene (E2) weitere Durchkontaktierungen (D13) zwischen modulseitiger (E1) und modulferner (E3) Metallisierungsebene vorhanden sind.

9. Vorrichtung nach Anspruch 7 oder 8, **dadurch gekennzeichnet, dass** die Durchkontaktierungen (D13) zwischen der modulseitigen (E1) und der modulfernen (E3) Metallisierungsebene in der mittleren Metallisierungsebene (E2) mittels einer Metallisierungsfläche (130) leitend miteinander verbunden sind.

10. Vorrichtung nach einem der vorangehenden Ansprüche, **dadurch gekennzeichnet, dass** am Ende der Triplate-Leitung ein Übergang auf eine Koplanarleitung vorhanden ist.

11. Vorrichtung nach Anspruch 10, **dadurch gekennzeichnet, dass** die Koplanarleitung zum Anschluss der Testeinrichtung mit einem koaxialen Stecker (55) verbunden ist.

12. Vorrichtung nach Anspruch 11, **dadurch gekennzeichnet, dass** auf der Triplateleitung entlang der Außenkontur des koaxialen Steckers (55) Durchkontaktierungen (D13) zwischen der modulseitigen (E1) und der modulfernen (E3) Metallisierungsebene der Triplate-Leitung vorhanden sind.

13. Vorrichtung nach einem der vorangehenden Ansprüche, **dadurch gekennzeichnet, dass** über das Leitungssubstrat (5) und weitere, innerhalb der Kontaktiereinheit (3) vorhandener Kontaktstifte Gleichstrom- und Steuersignale zwischen einer am Leitungssubstrat (5) angeordneten Leiterkarte (59) und dem T/R-Modul (1) übertragen werden können, wobei die Signalführung innerhalb der modulseitigen Metallisierungsebene (E1) der Triplate-Leitung erfolgt.

## Claims

1. Apparatus for making contact between a T/R module (1) and a test device for transmission of RF signals, having the following elements:
- a mechanically guided contact-making unit (3) which is in the form of a frame and has a plurality of contact elements (32) for making contact with the T/R module (1),
- a line substrate (5) which is arranged rigidly on the side of the contact-making unit (3) facing away from the module, is electrically connected to it and is in the form of a triplate line, via which the RF signals can be passed to the test device,
- one or more register pins (15) for defined alignment of the T/R module (1) with respect to the contact-making unit (3),
- a fixing unit for mechanical fixing of the T/R module (1),
- a shifting device (306), which has a plurality of inclined planes (308), by means of which a shifting movement of the shifting device (306) is converted to a movement of the contact-making unit (3) toward the T/R module (1) at right angles to the shifting direction, wherein, when the contact-making unit (3) reaches a defined final position, the contact is made with the T/R module (1) via the contact elements (31) in one process

2. Apparatus according to Claim 1, **characterized in that** the final position of the contact-making unit (3) is defined by a stop.

3. Apparatus according to Claim 1 or 2, **characterized in that** the contact elements (32) of the contact-making unit (3) are in the form of spring contact pins which touch metallic contact surfaces (81, 85a, 85b) on the line substrate (5) and T/R module (1) when the contact-making unit reaches the final position.

4. Apparatus according to Claim 3, **characterized in that** the contact surfaces (81, 85a, 85b) on the line substrate (5) and/or T/R module (1) have a central area (81, 85a) and an outer area (85b) surrounding it, wherein the central area (81, 85a) and the outer area (85b) are separated by an area with non-metalized dielectric.

5. Apparatus according to Claim 3 or 4, **characterized in that**, in order to shield the RF signal, the contact element (31) which connects the central area (81, 85a) of the contact surfaces is surrounded by further contact elements (31) which connect the outer area (85b) of the contact surfaces.

6. Apparatus according to one of the preceding claims, **characterized in that** the RF signal is passed from the metallization plane on the module side (E1) to the middle metallization plane (E2) of the triplate line.

7. Apparatus according to Claim 6, **characterized in that** the plated-through contact for the RF signal (D12) is surrounded by plated-through contacts (D13) between the metallization plane on the module side (E1) and the metallization plane remote from the module (E3) of the triplate line.

8. Apparatus according to one of the preceding claims, **characterized in that** further plated-through contacts (D13) are provided between the metallization plane on the module side (E1) and the metallization plane remote from the module (E3), on both sides along the inner conductor (60) of the middle metallization plane (E2).

9. Apparatus according to Claim 7 or 8, **characterized in that** the plated-through contacts (D13) between the metallization plane on the module side (E1) and the metallization plane remote from the module (E3) are conductively connected to one another in the middle metallization plane (E2) by means of a metallization surface (130).

10. Apparatus according to one of the preceding claims, **characterized in that** a junction to a coplanar line is provided at the end of the triplate line.

11. Apparatus according to Claim 10, **characterized in that** the coplanar line for connection of the test device is connected to a coaxial plug (55).

12. Apparatus according to Claim 11, **characterized in that** plated-through contacts (D13) are provided on the triplate line along the external contour of the coaxial plug (55), between the metallization plane on the module side (E1) and the metallization plane remote from the module (E3) of the triplate line.

13. Apparatus according to one of the preceding claims, **characterized in that** direct-current and control signals can be transmitted via the line substrate (5) and further contact pins, which are provided within the contact-making unit (3), between the T/R module (1) and a printed circuit board (59) which is arranged on the line substrate (5), wherein the signal is carried within the metallization plane on the module side (E1) of the triplate line.

## Revendications

1. Dispositif pour établir un contact entre un module T/R (1) et un système de test pour transmettre des signaux HF, comportant les éléments suivants :
- une unité d'établissement de contact (3) en forme de cadre, qui est guidée mécaniquement et qui comporte une pluralité d'éléments de contact (32) destinés à établir un contact avec le module T/R (1),
- un substrat de lignes (5) qui est disposé de manière fixe sur le côté de l'unité d'établissement de contact (3) orienté vers le module et qui lui est relié électriquement, et qui présente la forme d'une ligne triplaque, par l'intermédiaire duquel les signaux HF peuvent être transmis au système de test,
- une ou plusieurs goupilles de positionnement (15) assurant l'orientation définie du module T/R (1) par rapport à l'unité d'établissement de contact (3),
- une unité de fixation pour fixer mécaniquement le module T/R (1),
- un système poussoir (306) qui comprend plusieurs plans inclinés (308) au moyen desquels un coulissement du système poussoir (306) est converti en un déplacement de l'unité d'établissement de contact (3) sur le module T/R (1) perpendiculairement à la direction de coulissement, dans lequel, lorsque l'unité d'établissement de contact (3) a atteint une position finale définie, le contact avec le module T/R (1) est établi en une seule opération par l'intermédiaire des éléments de contact (31).

2. Dispositif selon la revendication 1, **caractérisé en ce que** la position finale de l'unité d'établissement de contact (3) est fixée par une butée.

3. Dispositif selon la revendication 1 ou 2, **caractérisé en ce que** les éléments de contact (32) de l'unité d'établissement de contact (3) sont réalisés sous forme de goupilles à ressort qui, lorsque la position finale de l'unité d'établissement de contact est atteinte, touchent des surfaces métalliques de contact (81, 85a, 85b) présentes sur le substrat de lignes (5) et le module T/R (1).

4. Dispositif selon la revendication 3, **caractérisé en ce que** les surfaces de contact (81, 85a, 85b) présentes sur le substrat de lignes (5) et/ou le module T/R (1) comprennent une région centrale (81, 85a) et une région extérieure (85b) entourant cette dernière,
dans lequel la région centrale (81, 85a) et la région extérieure (85b) sont séparées par une région diélectrique non métallisée.

5. Dispositif selon la revendication 3 ou 4, **caractérisé en ce que**, pour protéger le blindage du signal RF, l'élément de contact (31) reliant la région centrale (81, 85a) des surfaces de contact est entouré par d'autres éléments de contact (31) reliant la région extérieure (85b) des surfaces de contact.

6. Dispositif selon l'une des revendications précédentes, **caractérisé en ce que** le signal HF est guidé par l'intermédiaire d'un trou de connexion (D12) allant du plan de métallisation côté module (E1) vers le plan de métallisation central (E2) de la ligne triplaque.

7. Dispositif selon la revendication 6, **caractérisé en ce que** les trous de connexion destinés au signal HF (D12) sont entourés de trous de connexion (D13) entre le plan de métallisation côté module (E1) et le plan de métallisation éloigné du module (E3), de la ligne triplaque.

8. Dispositif selon l'une des revendications précédentes, **caractérisé en ce que** d'autres trous de connexion (D13) sont présents des deux côtés, le long du conducteur interne (60) du plan de métallisation central (E2) entre le plan de métallisation côté module (E1) et le plan de métallisation éloigné du module (E3).

9. Dispositif selon la revendication 7 ou 8, **caractérisé en ce que** les trous de connexion (D13) entre le plan de métallisation côté module (E1) et le plan de métallisation éloigné du module (E3) sont reliés entre eux de manière conductrice dans le plan de métallisation central (E2) par une surface de métallisation (130).

10. Dispositif selon l'une des revendications précédentes, **caractérisé en ce qu'**une transition vers une ligne coplanaire est présente à l'extrémité de la ligne triplaque.

11. Dispositif selon la revendication 10, **caractérisé en ce que** la ligne coplanaire est reliée à une fiche coaxiale (55) pour le raccordement du système de test.

12. Dispositif selon la revendication 11, **caractérisé en ce que** des trous de connexion (D13) sont présents sur la ligne triplaque le long du contour extérieur de la fiche coaxiale (55) entre le plan de métallisation côté module (E1) et le plan de métallisation éloigné du module (E3) de la ligne triplaque.

13. Dispositif selon l'une des revendications précédentes, **caractérisé en ce que** des signaux de courant continu et de commande peuvent être transmis entre une carte de circuit imprimé (59) disposée sur le substrat de lignes (5) et le module T/R (1) par l'intermédiaire du substrat de lignes (5) et d'autres goupilles de contact présentes à l'intérieur de l'unité d'établissement de contact (3), dans lequel le guidage du signal est effectué à l'intérieur du plan de métallisation côté module (E1) de la ligne triplaque.
